Europäisches Patentamt

European Patent Office

Office européen des brevets

(19)

(11) Numéro de publication : **0 204 624 B1**

## (12) FASCICULE DE BREVET EUROPEEN

(45) Date de publication du fascicule du brevet :
**03.07.91 Bulletin 91/27**

(51) Int. Cl.$^5$ : **H03K 17/18, H03K 17/08**

(21) Numéro de dépôt : **86401151.5**

(22) Date de dépôt : **30.05.86**

(54) **Dispositif de surveillance d'état d'un commutateur électrique et relais électrique comportant application.**

(30) Priorité : **30.05.85 FR 8508134**

(43) Date de publication de la demande :
**10.12.86 Bulletin 86/50**

(45) Mention de la délivrance du brevet :
**03.07.91 Bulletin 91/27**

(84) Etats contractants désignés :
**BE DE GB IT SE**

(56) Documents cités :
**WO-A-83/00590**
**DE-A- 1 810 707**
**GB-A- 1 166 357**
**US-A- 4 041 327**

(73) Titulaire : **MATRA**
**4 rue de Presbourg**
**F-75116 Paris (FR)**

(72) Inventeur : **Doittau, Pierre Olivier**
**4, rue Matemart**
**F-78640 Villiers St. Frederic (FR)**
Inventeur : **Moal, Hervé**
**10, Chemin Excelsior**
**D-78220 Velizy (FR)**

(74) Mandataire : **Fort, Jacques et al**
**CABINET PLASSERAUD 84, rue d'Amsterdam**
**F-75009 Paris (FR)**

EP 0 204 624 B1

## Description

L'invention a pour objet un dispositif de surveillance d'état de commutateur électrique présentant un état ouvert et un état fermé dans lequel il a une impédance inférieure de plusieurs ordres de grandeur à son impédance à l'état ouvert. Elle est applicable notamment dans toutes les installations en environnement sévère qui rendent insuffisamment fiable la surveillance de la commande du commutateur, l'état de ce dernier pouvant ne pas refléter celui de la commande. L'invention concerne également les relais devant être munis d'un tel dispositif de surveillance, et en particulier les relais statiques, auxquels on a reproché d'être sujets à des pannes de court-circuit du composant semiconducteur jouant le rôle de commutateur, ce qui rend particulièrement peu fiable la surveillance de la commande.

Il faut à ce sujet se souvenir que les relais électromécaniques traditionnels, satisfaisants du point de vue de la sécurité, ont en contrepartie des inconvénients nombreux, parmi lesquels un temps de réponse important qui limite leur fréquence de commutation, la présence de rebonds, la sensibilité à un environnement vibratoire, l'usure des contacts. Les relais statiques ont l'avantage d'avoir un temps de réponse beaucoup plus court, qui permet d'atteindre des cadences de commutation dépassant largement 10 kHz tout en acceptant, lorsqu'ils utilisent des composants semiconducteurs de type récent, des intensités comparables à celles des relais électromagnétiques. Mais le risque de court-circuits internes, indécelables lorsque la surveillance du relais s'effectue au niveau de la commande, a conduit jusqu'ici à des réticences à employer des relais statiques en environnement sévère, notamment sur les lanceurs, tels que ceux employés pour le lancement de satellites.

L'invention vise notamment à fournir un procédé et un dispositif de surveillance d'état de commutateur électrique, permettant de déterminer l'état réel du commutateur et non pas celui de sa commande, qu'il y ait ou non une source de tension continue appliquée au commutateur. Dans ce but, l'invention propose notamment un procédé selon la revendication 1 et un dispositif faisant application de ce procédé, suivant la revendication 2.

Un tel dispositif de surveillance est isolé galvaniquement du commutateur par le transformateur. De plus, il ne comporte que des organes statiques et capables de fonctionner en environnement sévère et, notamment, en présence d'un flux de rayonnement intense, ce qui ne serait pas le cas par exemple d'un coupleur opto-électronique d'isolement.

On voit que le dispositif de commande est basé sur l'utilisation d'un transformateur détectant une charge variable en alternatif, généralement à une fréquence élevée de façon à réduire le volume de l'oscillateur. Mais il suffirait en principe d'utiliser une fréquence d'oscillateur nettement supérieure à la fréquence maximale de commutation envisagée.

On connaît (GB-A-1 166 357) un dispositif qui ne vise pas à ce résultat, mais plutôt à éviter le risque de surcharge, en courant, par exemple provoqué par un court-circuit de la charge, et en interrompant l'alimentation. Une fraction de ce dispositif, constituée uniquement par un thyristor (Ty1), le primaire et le secondaire d'un transformateur et un réseau redresseur-résistance présente une similitude apparente avec une fraction du dispositif revendiqué.

Mais le thyristor (Ty1) ne peut être considéré comme étant un commutateur électrique commandé, ce qui implique un fonctionnement indépendant de celui du dispositif de surveillance. Il ne peut même être considéré comme un commutateur électrique commandé pour une autre raison encore car il n'est à l'état "fermé" que si, simultanément, il reçoit une tension de commande sur sa gâchette et une tension d'alimentation. La notion de surveillance d'état ouvert ou d'état fermé perd alors tout son sens puisqu'un tel "commutateur" n'est fermé que lorsqu'il y passe un courant.

L'invention propose également un relais statique, souvent monostable, à surveillance d'état par un dispositif du genre ci-dessus défini, muni d'un circuit de commande comprenant un oscillateur. Dans un premier mode de réalisation, cet oscillateur fournit deux signaux identiques en opposition de phase et le circuit de commande comprend un transformateur de commande du relais statique dont le secondaire est relié par l'intermédiaire d'un redresseur à l'électrode de commande du commutateur du relais et dont le primaire présente deux bornes extrêmes reliées à l'oscillateur et un point milieu muni de moyens de commande permettant à volonté de l'isoler ou de le porter à une tension de référence de façon à commander le relais.

L'oscillateur de commande du relais sera avantageusement d'un type fournissant des signaux rectangulaires et à fréquence élevée, souvent de plusieurs centaines de kHz. On pourra notamment utiliser un oscillateur magnétique.

Dans ce mode particulier de réalisation, l'oscillateur de commande peut être incorporé au dispositif de surveillance et utilisé pour commander le relais. Cette solution a cependant l'inconvénient que l'oscillateur doit fonctionner en permanence. Une autre solution consiste à prévoir deux oscillateurs indépendants. Dans ce cas, la commande du relais peut être effectuée à l'aide d'un transformateur simple, dont le primaire ne comporte pas de point milieu, la commande du relais s'effectuant par simple mise en action de l'oscillateur correspondant.

Quel que soit le mode de réalisation adopté, on voit que le dispositif de surveillance est complètement isolé galvaniquement, d'une part, du relais proprement

ment dit, d'autre part, de l'organe de commande de ce dernier.

Le relais statique à surveillance selon l'invention permet d'obtenir une sécurité équivalente à celle d'un relais électro-mécanique tout en ayant des performances de vitesse, d'absence de rebonds, d'absence d'usure et de tenue aux vibrations très supérieures. Dans la pratique, le temps de réponse peut être largement inférieur à la milliseconde. Toutes ces caractéristiques le rendent notamment utilisable dans les commandes de mécanismes et les commandes de mise à feu des lanceurs.

L'invention sera mieux comprise à la lecture de la description qui suit de modes particuliers d'exécution, donnés à titre d'exemples non limitatifs. La description se réfère aux dessins qui l'accompagnent, dans lesquels :

– la Figure 1 est un schéma de principe d'un relais statique à surveillance suivant un premier mode de réalisation de l'invention ;

– la Figure 2 est un synoptique d'un relais à surveillance constituant une variante.

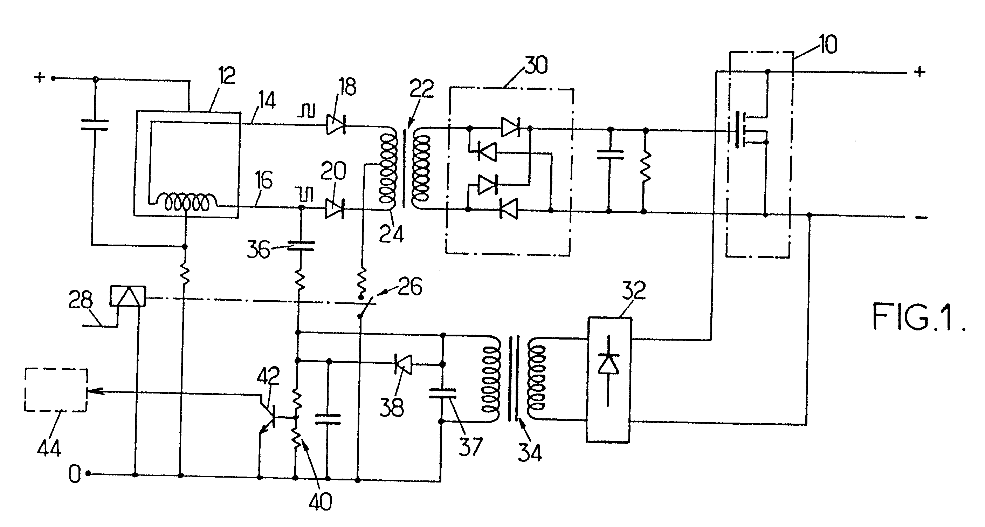

Le relais statique montré en Figure 1 est notamment utilisable pour des fréquences de commutation élevées et des courants à commuter importants. Le commutateur proprement dit 10 est constitué par un transistor à effet de champ à canal à dit "HEXFET". Le dispositif de surveillance qui lui est associé effectue une mesure d'impédance entre drain et source du transistor, la tension continue drain-source étant toujours inférieure à 2,5 V lorsque le transistor est conducteur. Le transistor peut notamment être du type IRF 150, qui permet de couper jusqu'à 50 V et 5 A en continu.

Le dispositif de commande du commutateur 10 comporte un oscillateur magnétique 12 qui peut être de type entièrement classique et fournit, sur deux bornes de sortie 14 et 16, des signaux rectangulaires de polarité opposée, appliqués en opposition de phase, par l'intermédiaire de diodes 18 et 20 aux bornes du primaire 24 d'un transformateur 22 de commande du commutateur. Le point milieu du bobinage primaire 24 du transformateur 22 est relié à un organe, représenté sous forme d'un relais électromécanique 26 mais qui sera généralement un transistor, permettant à volonté de le relier à la masse (pour fermer le commutateur) ou de l'isoler (pour ouvrir la commutateur) suivant la tension appliquée sur l'entrée de commande 28.

La tension aux bornes du secondaire du transformateur 22 est redressée par un redresseur double alternance 30 et appliquée à la grille du transistor à effet de champ constituant commutateur 10.

Le dispositif de surveillance de l'état du commutateur comporte un oscillateur qui, dans le mode de réalisation de la Figure 1, est l'oscillateur 12 de commande de ce commutateur. La surveillance d'état est réalisée par mesure de l'impédance en haute fréquence entre drain et source. Le dispositif comprend un redresseur 32 pouvant avoir la même constitution que le redresseur 30, dont les sorties sont reliées au drain et à la source du transistor à effet de champ de commutation et dont l'entrée est reliée au secondaire d'un transformateur 34. Le primaire de ce dernier est relié au condensateur 37, d'une part, et, d'autre part, par l'intermédiaire d'un condensateur 36 d'isolement en continu et d'une résistance, aux sorties de l'oscillateur 12. Un signal de sortie à la fréquence de l'oscillateur est prélevé au primaire du transformateur 34. Ce signal est appliqué, par l'intermédiaire d'une diode de redressement 38, d'un condensateur de filtrage et d'un pont diviseur 40 à résistance, à un élément commutateur fournissant une sortie en tout-ou-rien, compatible avec la nature d'un circuit logique 44 d'exploitation. Dans le mode de réalisation de la Figure 1, l'organe de commutation fournissant une sortie en tout-ou-rien est constitué par un transistor bipolaire 42 destiné à fournir une sortie compatible avec une logique TTL.

Cette logique 44 peut notamment être prévue pour assurer la commande de commutateurs de secours placés en série et en parallèle avec le commutateur 10, afin d'éviter le point de panne unique à la fermeture et à l'ouverture.

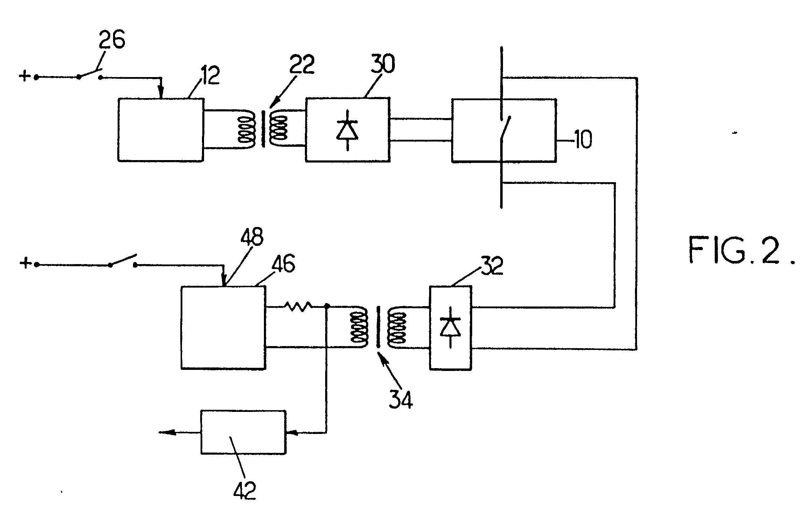

Le mode de réalisation montré en Figure 1 a l'avantage de n'exiger qu'un seul oscillateur 12. En contrepartie, cet oscillateur doit fonctionner en permanence, puisqu'il alimente le dispositif de surveillance. Le mode de réalisation montré en Figure 2, sur laquelle les éléments correspondant à ceux de la Figure 1 sont désignés par le même numéro de référence, comporte deux oscillateurs, ce qui complique légèrement le système. Mais, en contrepartie, l'oscillateur 12 de commande du commutateur 10 ne fonctionne que lorsque celui-ci doit être rendu passant, ce qui permet par ailleurs de supprimer la commande constituée par l'organe commutateur sur la Figure 1.

Le mode de réalisation de la Figure 2 comprend, en plus de l'oscillateur de commande 12, un oscillateur 46 appartenant au dispositif de surveillance, muni d'une entrée 48 d'alimentation assurant la mise en fonctionnement du dispositif. Le commutateur 10 est commandé fermé ou ouvert selon que l'oscillateur 12 est alimenté ou non. La sortie de surveillance est prélevée sur le primaire du transformateur 34 et peut également commander un organe de sortie en tout-ou-rien 42, qui peut encore être constitué par un transistor.

A titre d'exemple, on peut indiquer qu'un dispositif conforme à la Figure 1 a été réalisé en utilisant un oscillateur fonctionnant à une fréquence de 240 kHz. Le retard de commutation était inférieur à 20 microsecondes à la fermeture, à 400 microsecondes à l'ouverture dans le cas d'emploi d'un transistor "HEXFET". Le temps de réponse du dispositif de surveillance était inférieur à 200 microsecondes aussi bien dans le cas de l'ouverture que dans le cas de la fermeture du commutateur.

L'invention ne se limite évidemment pas aux modes particuliers de réalisation qui ont été représentés et décrits à titre d'exemples et il doit être entendu que la portée du présent brevet s'étend à toute variante restant dans le cadre des équivalences.

**Revendications**

1. Procédé de surveillance d'état d'un commutateur électrique (10) présentant un état ouvert et un état fermé dans lequel il a une impédance en courant alternatif inférieure de plusieurs ordres de grandeur à l'impédance à l'état ouvert, caractérisé en ce qu'un dispositif de surveillance détermine l'état réel du commutateur, même s'il est fermé sans pour autant être alimenté, le dispositif comprenant un transformateur d'isolement (34) dont un des enroulements est relié, par l'intermédiaire d'un redresseur (32), aux bornes de sortie du commutateur (10) et dont l'autre enroulement est en circuit avec un oscillateur (12 ou 46) en fonctionnement permanent lors de la surveillance, présentant une impédance nettement supérieure à celle dudit autre enroulement lorsque le commutateur (10) est fermé, ainsi que des moyens (42, 44) d'analyse d'un signal électrique prélevé sur ledit autre enroulement et représentatif de ladite impédance du commutateur.

2. Dispositif de surveillance d'état d'un commutateur électrique (10) présentant un état ouvert et un état fermé dans lequel il a une impédance inférieure de plusieurs ordres de grandeur à l'impédance à l'état ouvert pour la mise en oeuvre du procédé selon la revendication 1, caractérisé en ce qu'il comprend un transformateur d'isolement (34) dont un des enroulements est relié, par l'intermédiaire d'un redresseur (32) aux bornes de sortie du commutateur (10) et dont l'autre enroulement est en circuit avec un oscillateur (12 ou 46) en fonctionnement permanent lors de la surveillance, présentant une impédance nettement supérieure à celle dudit autre enroulement lorsque le commutateur est fermé, ainsi que des moyens (42, 44) d'analyse de signal électrique prélevé sur ledit autre enroulement et représentatif de ladite impédance du commutateur ledit oscillateur (12 ou 46) ayant une fréquence d'oscillation supérieure à la fréquence maximum de commutation du commutateur et ledit signal étant prélevé à une extrémité, reliée à l'oscillateur, dudit autre enroulement, la seconde extrémité dudit autre enroulement étant à un potentiel de référence.

3. Relais statique à surveillance d'état comprenant un composant semiconducteur constituant commutateur (10), un circuit de commande comprenant un oscillateur (12) relié par l'intermédiaire d'un redresseur à une électrode de commande du composant et un dispositif de surveillance suivant la revendication 2, caractérisé en ce que l'oscillateur (12) du circuit de commande constitue également l'oscillateur du circuit de surveillance et en ce que ledit oscillateur fournit deux signaux identiques en opposition de phase aux bornes extrêmes du primaire (24) d'un transformateur de commande dont le secondaire est relié par un redresseur (30) à l'électrode de commande du composant semiconducteur, le point milieu du primaire étant muni de moyens de commande (26) permettant à volonté de l'isoler ou de le porter à une tension de référence de façon à commander le relais.

4. Relais statique à surveillance d'état comprenant un composant semiconducteur constituant commutateur (10), un circuit de commande comprenant un oscillateur (12) relié par l'intermédiaire d'un redresseur à une électrode de commande du composant, et un dispositif de surveillance suivant la revendication 2, caractérisé en ce que le circuit de commande comprend un oscillateur indépendant de l'oscillateur du dispositif de surveillance et attaque directement le transformateur de commande.

5. Relais selon l'une quelconque des revendications 3 et 4, caractérisé en ce que l'oscillateur du circuit de commande est à fréquence de plusieurs centaines de KHz.

**Ansprüche**

1. Verfahren zur Überwachung des Zustands eines elektrischen Schalters (10), der eine geöffnete und eine geschlossene Stellung aufweist, in der er eine Wechselstromimpedanz hat, die um einige Größenordnungen geringer ist als die Impedanz in geöffnetem Zustand, **dadurch gekennzeichnet, daß** eine Überwachungseinrichtung den tatsächlichen Zustand des Schalters bestimmt, auch wenn er geschlossen ist, ohne daß er gespeist wird, wobei die Einrichtung einen Isoliertransformator (34), dessen eine Wicklung über einen Gleichrichter (32) mit den Anschlüssen des Schalterausgangs (10) verbunden ist und dessen andere Wicklung in einem Schaltkreis mit einem während der Überwachung im Dauerbetrieb befindlichen Oszillator (12, oder 46) geschaltet ist, der eine Nettoimpedanz hat, die größer ist als die der anderen Wicklung, wenn der Schalter (10) geschlossen ist, sowie eine Analyse-Einrichtung (42, 44) für ein elektrisches Signal aufweist welches an der anderem Wicklung abgegriffen wird und der Impedanz des Schalters entspricht.

2. Einrichtung zur Überwachung des Zustands eines elektrischen Schalters (10), welcher eine geöffnete und eine geschlossene Stellung aufweist, in der er eine Impedanz hat, die um einige Größernordnungen geringer ist als die Impedanz in geöffnetem Zustand, zur Durchführung des Verfahrens, **dadurch gekennzeichnet, daß** sie einen Isolationstransformator (34), dessen eine Wicklung über einen Gleichrichter (32) mit den Anschlüssen des Ausgangs des Schalters (10) verbunden ist und dessen andere Wicklung in einem Schaltkreis mit einem während der Überwachung im Dauerbetrieb befindlichen Oszillator (12, oder 46) geschaltet ist, der eine Nettoimpedanz hat, die größer ist als die der anderen Wicklung, wenn der Schalter (10) geschlossen ist, sowie eine Analyse-Einrichtung (42, 44) für ein elektrisches Signal aufweist, welches an der anderem Wicklung abgegriffen wird und der Impedanz des Schalters entspricht, wobei der Oszillator (12 oder 46) eine Schwingungsfrequenz hat, die höher als die maximale Schaltfrequenz des Schalters ist und das Signal an einem mit dem Oszillator verbundenen Ende der anderen Wicklung abgegriffen wird, wobei das andere Ende der anderen Wicklungen an einer Bezugsspannung liegt.

3. Statisches Relais zur Zustandsüberwachung mit einem den Schalter (10) darstellenden Halbleiterbauteil, einem Steuerkreis mit einem Oszillator (12), der über einen Gleichrichter mit einer Steuerelektrode des Bauteils verbunden ist, und einer Überwachungseinrichtung nach Anspruch 2, **dadurch gekennzeichnet, daß** der Oszillator (12) des Steuerkreises gleichzeitig der Oszillator des Überwachungskreises ist, und daß der Oszillator zwei identische Signale mit entgegengesetzten Phasen an die Endanschlüsse des Primärstromkreises eines Steuertransformators liefert, dessen Sekundärstromkreis über einen Gleichrichter (30) mit der Steuerelektrode des Halbleiterbauteils verbunden ist, wobei der Mittelpunkt des Primärstromkreises eine Steuereinrichtung (26) aufweist, die es ermöglicht, ihn nach Wunsch zu trennen oder auf einer Bezugsspanung zu halten, die zum Steuern des Relais geeignet ist.

4. Statisches Relais zur Zustandsüberwachung mit einem den Schalters (10) darstellenden Halbleiterbauteil, einem Steuerkreis mit einem Oszillator (12), der über einen Gleichrichter mit einer Steuerelektrode des Bauteils verbunden ist, und mit einer Überwachungseinrichtung nach Anspruch 2, **dadurch gekennzeichnet, daß** der Steuerkreis einen Oszillator aufweist, der von dem Oszillator der Überwachungseinrichtung unabhängig ist und den Steuertransformator direkt ansteuert.

5. Relais nach einem der Ansprüche 3 und 4, **dadurch gekennzeichnet, daß** der Oszillator des Steuerkreises eine Frequenz von mehreren Hunderten kHz hat.

## Claims

1. A process for monitoring a state of an electrical switch (10) having an open condition and a closed condition in which it has an AC impedance lower than the impedance in open condition by several orders of magnitude, characterized in that a monitoring device indicates the actual condition of the switch, even if it is closed without being fed, the device comprising an insulating transformer (34) having one winding connected, through a rectifier (32), to the output terminals of the switch (10) and having another winding which is in circuit with an oscillator (12 or 46) in continuous operation during monitoring, having an impedance which is significantly higher than that of said other winding when the switch (10) is closed, as well as means (42, 44) for analyzing an electrical signal derived from said other winding and representing said impedance of the switch.

2. A device for monitoring a state of an electrical switch (10) having an open condition and a closed condition in which its impedance is lower than the impedance when in open condition by several orders of magnitude, for carrying out the process according to claim 1, characterized in that it comprises an insulating transformer (34) having a winding which is connected, through a rectifier (32), to the output terminals of the switch (10) and another winding which is in circuit with an oscillator (12 or 46) in continuous operation during monitoring, having an impedance which is significantly higher than that of said other winding when the switch is closed, as well as means (42, 44) for analyzing an electric signal derived from said other winding and representing said impedance of the switch, said oscillator (12 or 46) having an oscillation frequency which is higher than the maximum switching frequency of the switch and said signal being derived from one end, connected to the oscillator, of said other winding, the second end of said other winding being at a reference voltage.

3. Static relay with state monitoring, comprising a semiconductor component constituting the switch (10), a control circuit comprising an oscillator (12) connected via a rectifier to a control electrode of the component and a monitoring device according to claim 2, characterized in that the oscillator (12) of the control circuit also constitutes the oscillator of the monitoring circuit and in that said oscillator delivers two identical signals in phase opposition to the end terminals of the primary (24) of a control transformer whose secondary is connected through a rectifier (30) to the control electrode of the semiconductor component, the mid-point of the primary being provided with control means (26) for selectively insulating it or bringing it to a reference voltage for controlling the relay.

4. Static relay with state monitoring comprising a semiconductor component constituting the switch (10), a control circuit comprising an oscillator (12) connected through a rectifier to a component control electrode and a monitoring device according to claim 2, characterized in that the control circuit comprises an oscillator which is independent of the oscillator of the monitoring device and directly drives the control transformer.

5. Relay according to any one of claims 3 and 4, characterized in that the oscillator of the control circuit has a frequency of several hundreds of KHz.

FIG.1.

EP 0 204 624 B1

FIG. 2.

EP 0 204 624 B1